# EUROPÄISCHE PATENTANMELDUNG

(11) **EP 3 096 180 A1**
(43) Veröffentlichungstag der Anmeldung: **23.11.2016**
(21) Anmeldenummer: 15168530.2
(22) Anmeldetag: 20.05.2015
(51) Int. Cl.: G02F 1/00, G02B 6/00, H01S 5/062

(54) **VERFAHREN ZUR VERBREITERUNG DES FREQUENZSPEKTRUMS EINER ELEKTROMAGNETISCHEN WELLE UND BAUELEMENT ZU SEINER REALISIERUNG**

(71) Anmelder: PHILIPPS-UNIVERSITÄT MARBURG, 35037 Marburg (DE)
(72) Erfinder: Koch, Martin, 35037 Marburg (DE); Velauthapillai, Ajanthkrishna, 35037 Marburg (DE)
(74) Vertreter: Stumpf, Peter

(57) **Zusammenfassung**

Die Erfindung betrifft ein Verfahren zur Verbreiterung des Frequenzspektrums einer elektromagnetischen Welle und ein Bauelement zur Realisierung dieses Verfahrens. Eine elektromagnetische Welle (1) wird in eine, durch den Kontakt zweier benachbarter aktiver Schichten (A1,A2) gebildete, Grenzfläche (F) mit elektrisch gleichrichtender Wirkung (i.e. Schottky Kontakt), eingekoppelt. Die Welle schreitet entlang dieser Grenzfläche (F) fort, wobei sie einen unipolaren Stromuls (3) induziert, welcher einen Bipolarpuls mit verkürzter Pulsdauer erzeugt. Dieser überlagert sich mit der eingekoppelten elektromagnetischen Welle. Diese durch die Überlagerung gebildete elektromagnetische Welle (2) weist ein im Vergleich zur eingekoppelten elektromagnetische Welle (1) verbreitertes Frequenzspektrum auf und wird aus der Grenzfläche (F) ausgekoppelt. Das Verfahren und das Bauelement sind in einem breiten Bereich des elektromagnetischen Spektrums, vom Radiowellen- bis in den UV-Bereich, einsetzbar. Besonders vorteilhaft ist ihr Einsatz im Terahertz(THz)-Frequenzbereich.

## Beschreibung

### Gebiet der Erfindung

Die Erfindung betrifft ein Verfahren zur Verbreiterung des Frequenzspektrums einer elektromagnetischen Welle und ein Bauelement zur Realisierung dieses Verfahrens. Das Verfahren und das Bauelement sind in einem breiten Bereich des elektromagnetischen Spektrums, vom Radiowellen- bis in den UV-Bereich, einsetzbar. Besonders vorteilhaft ist ihr Einsatz im Terahertz(THz)-Frequenzbereich.

### Stand der Technik

Techniken zur Änderung der Ausgangsfrequenz von Quellen für elektromagnetische Wellen sind für alle Bereiche des elektromagnetischen Spektrums bekannt. Meist handelt es sich um Mischverfahren, bei denen aus mindestens zwei Ausgangsfrequenzen f₁ und f₂ die Mischfrequenzen f₁ + f₂ sowie f₁ - f₂ erzeugt werden.

Ebenso werden nichtlineare optische Effekte ausgenutzt, um die Ausgangsfrequenz von Laserquellen zu vervielfachen. So sind Laserquellen verfügbar, bei denen die Frequenz eines 1064-nm-IR-Lasers verdoppelt oder verdreifacht wird, um eine im sichtbaren Bereich (λ = 532 nm) bzw. im UV-Bereich (λ = 355 nm) emittierende Quelle zu erhalten.

In den vorab genannten Verfahren werden somit diskrete Frequenzen manipuliert (gemischt oder vervielfacht), woraus wieder diskrete Frequenzen resultieren. Es erfolgt keine Verbreiterung eines kontinuierlichen Frequenzbereichs.

Von besonderem Interesse ist eine Frequenzverbreiterung im THz-Frequenzbereich, der üblicherweise zwischen 0,1 THz und 10 THz lokalisiert wird. Er liegt im elektromagnetischen Spektrum zwischen dem Mikrowellen- und dem infraroten Frequenzbereich.

Der THz-Frequenzbereich ist bisher nur eingeschränkt für industrielle Standardprüfverfahren nutzbar, da die bisher verfügbaren THz-Quellen oberhalb von 1 THz eine unzureichende Ausgangsleistung aufweisen. Zu unterscheiden sind dabei cw-Quellen (continuous wave), die eine oder mehrere diskrete, vorzugsweise durchstimmbare, Ausgangsfrequenzen liefern, und gepulste Quellen, die ein kontinuierliches Spektrum liefern.

cw-THz-Quellen basieren z. B. auf GaAs-Schottky-Dioden, die die Frequenz eines eingestrahlten Signals, z. B. eines Mikrowellensignals, vervielfachen und somit in den THz-Frequenzbereich anheben. So beschrieb die Firma Virginia Diodes Inc. auf dem 2. EPFL THz Workshop (2014) einen Schottky-Dioden-Vervielfacher, der ein Mikrowellensignal (40 GHz, 1,5 W) in ein THz-Signal (0,32 THz, 20 mW) wandelt, wobei allerdings die Ausgangsleistung um nahezu 2 Größenordnungen sinkt. Durch eine weitere Vervielfachung ist auch der Frequenzbereich oberhalb 1 THz erreichbar, jedoch nur noch mit einer Ausgangsleistung im µW-Bereich, was durch sehr lange (für industrielle Anwendungen ungeeignete) Messzeiten kompensiert werden muss.

Gepulste THz-Quellen basieren auf fs-IR-Lasern, die mit einem THz-Emitter, z. B. einer photoleitenden Antenne, verbunden sind. Eine vom fs-IR-Laser erzeugte infrarote Kurzpulsfolge wird am THz-Emitter in eine THz-Pulsfolge mit derselben Pulswiederholrate umgesetzt. Die Pulsdauer τ eines einzelnen THz-Pulses dieser Folge liegt dabei im Bereich einiger ps, z. B. τ = 2 ps...5 ps. Ein solcher THz-Puls weist ein kontinuierliches Spektrum auf, dessen Schwerpunkt durch 1/τ bestimmt wird und somit im Bereich 1/τ = 0,2 THz...0,5 THz liegt. Dieses kontinuierliche Spektrum dehnt sich typischerweise bis zu 3,5 THz aus, jedoch setzt bereits in unmittelbarer Nähe des Schwerpunkts ein starker Abfall seiner Intensität ein.

Solche gepulsten THz-Quellen finden Verwendung in THz-Zeitbereichsspektrometern. Bisher muss bei der Aufnahme von THz-Spektren der erwähnte Intensitätsabfall ab ca. 1 THz durch stark verlängerte Messzeiten ausgeglichen werden, sodass der Frequenzbereich oberhalb von ca. 1 THz nur mit einem unwirtschaftlich hohen Aufwand zugänglich ist. Insbesondere kann er nicht für industrielle Routineprüfungen genutzt werden.

Es besteht daher ein dringender Bedarf an gepulsten THz-Quellen, die auch im Frequenzbereich oberhalb 1 THz eine für den wirtschaftlichen Einsatz ausreichend hohe THz-Leistung liefern.

Grundsätzlich bekannt sind auch Schottky-Kontakt-Wellenleiter, die ein Ansatzpunkt für die in dieser Anmeldung beschriebene Erfindung sind. Bisher nicht beschrieben im Stand der Technik wurde aber der Einsatz solcher Schottky-Kontakt-Wellenleiter zur Formung elektromagnetischer Wellen.

Lediglich völlig andere Anwendungen von Schottky-Kontakt-Wellenleitern sind bekannt: So beschreibt die EP0378112A2 "Anordnung zum optischen Koppeln eines optischen Wellenleiters um eine Photodiode auf einem Substrat aus Silizium" einen Wellenleiter, der über einen großflächigen Schottky-Kontakt mit einer Photodiode verbunden ist. Ein kontinuierliches optisches Signal (IR-Strahlung mit einer Wellenlänge 1,3 µm ≤ λ ≤ 1,6 µm) wird in den Wellenleiter eingekoppelt und erzeugt elektrische Ladungsträger, die über Leckwellenkopplung in die Photodiode geleitet werden. Diese Anordnung realisiert somit die Umwandlung eines optischen Signals in ein elektrisches Signal, das von einer Photodiode registriert wird. Sie dient somit zur Detektion eines optischen Signals, ist aber nicht dazu geeignet, eine elektromagnetische Welle, z. B. die Pulse einer elektromagnetischen Pulsfolge, so zu formen, dass deren Frequenzspektrum verbreitert wird. Außerdem ist die Anordnung nicht für Anwendungen außerhalb des optischen Frequenzbereichs, insbesondere nicht für Anwendungen im THz-Frequenzbereich, vorgesehen.

Weder für den THz-Frequenzbereich noch für die angrenzenden Frequenzbereiche ist ein Verfahren bekannt, um ein Frequenzspektrum unabhängig von dem jeweils verwendeten Emitter zu verbreitern. Ebenso sind auch keine Bauelemente bekannt, die zur Realisierung eines solchen Verfahrens geeignet wären.

### Aufgabe der Erfindung

Die Aufgabe der vorliegenden Erfindung besteht darin, ein Verfahren zur Verbreiterung des Frequenzspektrums einer elektromagnetischen Welle, insb. des Frequenzspektrums der Pulse einer gepulsten elektromagnetischen Welle, anzugeben und ein zur Realisierung dieses Verfahrens geeignetes einfaches und kostengünstiges Bauelement bereitzustellen. Das Verfahren und das Bauelement sollen in einem breiten Bereich des elektromagnetischen Spektrums, vom Radiowellen- bis in den UV-Bereich, einsetzbar sein. Da ein Bedarf für ein solches Verfahren und das dafür benötigte Bauelement insbesondere im THz-Frequenzbereich (ca. 0,5 THz bis ca. 10 THz) besteht, ist eine für diesen Spektralbereich optimierte Ausführungsform eines solchen Bauelements anzugeben, welche die Nachteile der im Stand der Technik genannten Lösungen überwindet.

### Lösung der Aufgabe

Die Aufgabe der Erfindung wird gelöst durch ein Verfahren zur Verbreiterung eines Frequenzspektrums einer elektromagnetischen Welle mit den Merkmalen des Anspruchs 1, ggf. ergänzt durch die Merkmale der Unteransprüche 2 bis 5. Ferner wird die Aufgabe der Erfindung gelöst durch ein Bauelement mit den Merkmalen des Anspruchs 6, ggf. ergänzt durch die Merkmale der Unteransprüche 7 bis 11.

Vorzugsweise ist das Bauelement ausgestattet mit einem eine elektrisch gleichrichtende Wirkung aufweisenden Metall-Halbleiter-Kontakt, an dem durch eine eingekoppelte elektromagnetische Welle, die entlang des Metall-Halbleiter-Kontakts fortschreitet und dabei eine Dämpfung erfährt, ein unipolares Stromsignal induziert wird. Ein solcher Metall-Halbleiter-Kontakt mit gleichrichtender Wirkung ist als Schottky-Kontakt bekannt. Durch die flächenhafte Ausführung des Schottky-Kontakts, vorzugsweise unter Verwendung mechanisch stabilisierender Substrate, wird ein Schottky-Kontakt-Wellenleiter SKW realisiert. Handelt es sich bei der eingekoppelten elektromagnetischen Welle um eine Folge von elektromagnetischen Bipolarpulsen, so erfährt jeder eingekoppelte elektromagnetische Bipolarpuls beim Durchlaufen des SKW eine Dämpfung und induziert im SKW einen unipolaren Stromplus (d. h. einen gleichgerichteten Strompuls), der aufgrund der Unterdrückung einer Polarität kürzer als der eingekoppelte elektromagnetische Bipolarpuls ist. Gemäß den Maxwell'schen Gleichungen erzeugt dieser unipolare Strompuls einen weiteren, in gleicher Weise verkürzten, elektromagnetischen Bipolarpuls, der sich dem gedämpften elektromagnetischen Bipolarpuls überlagert. Aus dieser Überlagerung resultiert ein im Vergleich zum eingekoppelten elektromagnetischen Bipolarpuls zeitlich verkürzter elektromagnetischer Bipolarpuls mit verbreitertem Frequenzspektrum, der vom SKW emittiert wird. Bei Einkopplung einer Folge von Bipolarpulsen in den SKW emittiert dieser somit eine Folge von Bipolarpulsen, die ein, im Vergleich zum Frequenzspektrum der eingekoppelten Bipolarpulse, verbreitertes Frequenzspektrum aufweisen. Eine solche Verbreiterung eines Frequenzspektrums ist in einem breiten Bereich des elektromagnetischen Spektrums, vom Radiowellen- bis in den UV-Bereich, realisierbar, indem die Abmessungen des Bauelements, insbesondere die Abmessungen des Schottky-Kontakts und die Substratdicken, an die jeweilige Wellenlänge angepasst werden.

Verallgemeinerungen dieser bevorzugten Lösung sind in der nachfolgenden detaillierten Darstellung enthalten.

### Detaillierte Darstellung der erfindungsgemäßen Lösung

Die Erfindung nutzt den physikalischen Effekt der elektrischen Gleichrichtung an Grenzflächen technisch aus, um eine Verbreiterung des Frequenzspektrums einer elektromagnetischen Welle zu erzielen. Die elektromagnetische Welle kann ein gepulstes Signal, aber auch ein kontinuierliches Signal sein. Dazu wird ein erfindungsgemäßes Bauelement beschrieben, das zumindest zwei benachbarte Schichten A₁, A₂ aufweist, die zur Realisierung des gleichrichtenden Effekts zwingend erforderlich sind. Sie werden deshalb als aktive Schichten bezeichnet. Unter "zwei benachbarten Schichten" sind in dieser Anmeldung zwei Schichten zu verstehen, die unmittelbar übereinander liegen und somit eine gemeinsame Grenzfläche F aufweisen.

Als aktive Schichten A₁, A₂ sind alle Materialien einsetzbar, bei denen, wenn sie miteinander in Kontakt gebracht werden, eine elektrisch gleichrichtende Wirkung an der gebildeten Grenzfläche F auftritt. Insbesondere sind einsetzbar (wobei die Materialien beider Schichten A₁ und A₂ stets vertauschbar sind):
- zwei entgegengesetzt dotierte Halbleitermaterialien (Schicht A₁: p-dotierter Halbleiter, Schicht A₂: n-dotierter Halbleiter), die einen p-n-Übergang bilden,
- ein Metall und ein dotierter Halbleiter (Schicht A₁: Metall, Schicht A₂: n-dotierter oder p-dotierter Halbleiter), die einen Metall-Halbleiter-Übergang (Schottky-Kontakt), bilden.

Die letztgenannte Kombination Metall-Halbleiter ist bevorzugt, da Metall-Halbleiter-Übergänge mit elektrisch gleichrichtender Wirkung, bekannt als Schottky-Kontakte, im Vergleich zu p-n-Übergängen kürzere Schaltzeiten und (in Durchlassrichtung) höhere Ströme gewährleisten. Metall-Halbleiter-Übergänge können auch ohmsche Kontakte (ohne gleichrichtende Wirkung) ausbilden, solche Übergänge werden bei der vorliegenden Erfindung jedoch nicht verwendet.

Die nachfolgende Beschreibung fokussiert sich daher auf ein erfindungsgemäßes Bauelement, das als Schottky-Kontakt-Wellenleiter SKW ausgeführt ist, wobei als Halbleiter ein n-dotierter Halbleiter verwendet wird. Die Übertragung auf den Fall eines SKW mit einem p-dotierten Halbleiter ist für den Fachmann problemlos möglich.

Der SKW weist keine eigene Spannungsversorgung auf und kann daher als passives Bauelement mit beliebigen Emittern von elektromagnetischen Wellen kombiniert werden. Besonders vorteilhaft einsetzbar ist der SKW in einem THz-Messgerät, wobei er in dessen THz-Pfad zwischen dem THz-Emitter und dem Ort der Probenpositionierung angeordnet wird. THz-Messgeräte umfassen hier THz-Zeitbereichsspektrometer, THz-Quasizeitbereichsspektrometer sowie THz-Interferometer.

### Vorgänge am Schottky-Kontakt

Ein Schottky-Kontakt SK ist wesentliches Merkmal jeder Schottky-Diode. Er verbindet ein Metall mit einem n-dotierten Halbleiter und besitzt eine gleichrichtende Wirkung: In Durchlassrichtung ist das Metall positiv (Anode), der n-Halbleiter negativ gepolt (Katode), es fließt ein Elektronenstrom vom Halbleiter in das Metall. In Sperrrichtung (Metall als Katode, n-Halbleiter als Anode gepolt) ist kein Stromfluss möglich. Der Schottky-Kontakt kann, wie erwähnt, auch als Übergang zwischen einem Metall und einem p-dotierten Halbleiter ausgeführt werden, wobei die o. g. Polungen umzukehren sind. Schottky-Dioden ermöglichen die Gleichrichtung starker hochfrequenter Wechselströme.

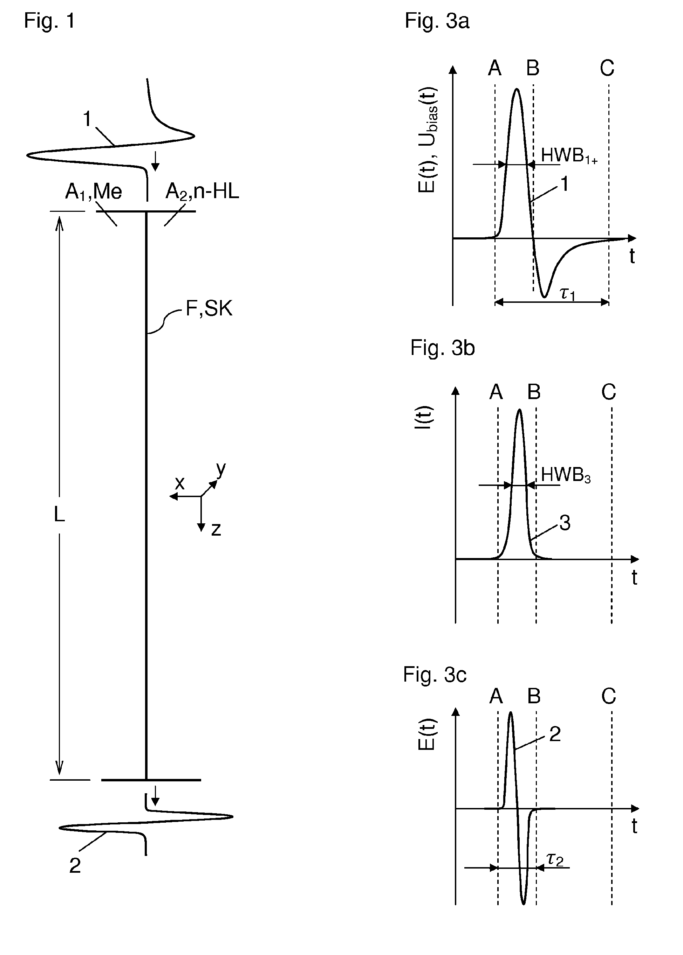

Zur Herstellung eines erfindungsgemäßen SKW wird der Schottky-Kontakt SK flächenhaft ausgeführt. Die bei Einkopplung eines elektromagnetischen Bipolarpulses in einen solchen flächenhaft ausgeführten Schottky-Kontakt SK auftretenden Vorgänge werden in Fig. 1 veranschaulicht.

Fig. 1 zeigt eine Schnittdarstellung, in welcher die Grenzfläche mit gleichrichtender Wirkung F, hier als Schottky-Kontakt SK ausgebildet, als senkrechte Linie zwischen zwei aktiven Schichten A₁, A₂, hier einer Metallschicht Me und einer Schicht eines n-dotierten Halbleiters n-HL abgebildet wird. Zum Zwecke der Orientierung ist ein orthogonales Koordinatensystem x, y, z eingezeichnet. Der Schottky-Kontakt SK, der eine Länge L (in der Pulsausbreitungsrichtung z hat) aufweist, setzt sich senkrecht zur Zeichenebene (in y-Richtung) fort. Die x-Richtung verläuft senkrecht zur Ebene des Schottky-Kontakts SK (y-z-Ebene). Schematisch dargestellt ist ein in den Schottky-Kontakt SK eingekoppelter Bipolarpuls 1 sowie ein am gegenüberliegenden Ende des Schottky-Kontakts SK ausgekoppelter Bipolarpuls 2 mit einer (im Vergleich zum eingekoppelten Bipolarpuls 1) reduzierten Pulsdauer. Die Ausbreitungsrichtung beider Pulse (parallel zur z-Richtung) ist jeweils durch einen Pfeil gekennzeichnet. Die Dicken der aneinander angrenzenden Schichten Me, n-HL werden bei der unten folgenden Beschreibung der technischen Ausführung des Schottky-Kontakt-Wellenleiters SKW spezifiziert.

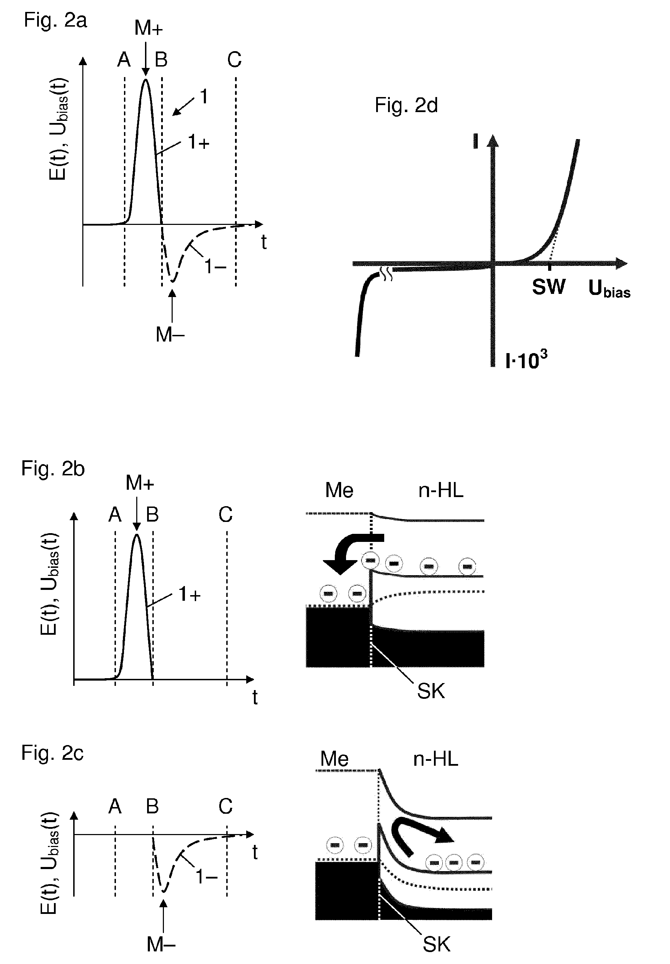

Die reduzierte Pulsdauer des Bipolarpulses 2 resultiert aus der erfindungsgemäßen Ausnutzung der gleichrichtenden Wirkung des Schottky-Kontakts SK, verursacht durch die Ausbildung einer Potenzialbarriere im Bereich der den Schottky-Kontakt SK bildenden Metall-Halbleiter-Grenzfläche F. Die entsprechenden Abläufe erläutert Fig. 2.

Fig. 2a zeigt den zeitlichen Verlauf der elektrischen Feldstärke E(t) des eingekoppelten Bipolarpulses 1. Er weist einen zwischen den Punkten A und B liegenden Pulsabschnitt 1+ (durchgezogene Linie) auf, in dem das elektrische Feld so gerichtet ist, dass bei Einkopplung in den Schottky-Kontakt zunächst eine "forward bias", d. h. eine Vorspannung in Durchlassrichtung, erzeugt wird (entsprechend einer negativen Polung des n-Halbleiters n-HL und einer positiven Polung des Metalls Me). Im Punkt M+ durchläuft das elektrische Feld sein Maximum, um dann im Punkt B (Nulldurchgang) seine Richtung zu wechseln, sodass der zwischen B und C liegende, durch eine Strichlinie dargestellte, Pulsabschnitt 1- (mit einem Minimum im Punkt M-) bei Einkopplung in den Schottky-Kontakt eine "reverse bias", d. h. eine Vorspannung in Sperrrichtung, erzeugt (entsprechend einer positiven Polung des n-Halbleiters n-HL und einer negativen Polung des Metalls Me).

Fig. 2b zeigt links den Abschnitt 1+ des Bipolarpulses 1, der am Schottky-Kontakt SK eine Vorspannung in Durchlassrichtung erzeugt, und rechts das Bänderschema in einem Abschnitt des Schottky-Kontakts, der gerade von dem mit M+ bezeichneten Maximum des elektrischen Feldes durchlaufen wird. Die Potenzialbarriere wird um die (maximale) "forward bias" verringert, es erfolgt ein nahezu ungehinderter Elektronenstrom vom n-Halbleiter n-HL in das Metall Me, der durch einen Pfeil symbolisiert ist.

Fig. 2c zeigt links den Abschnitt 1-des Bipolarpulses 1, der am Schottky-Kontakt eine Vorspannung in Sperrrichtung erzeugt, und rechts das Bänderschema in einem Abschnitt des Schottky-Kontakts, der gerade von dem mit M- bezeichneten Minimum des elektrischen Feldes durchlaufen wird. Die Potenzialbarriere wird um die (maximale) "reverse bias" erhöht, es ist, bis auf einen vernachlässigbar kleinen Sperrstrom, kein Elektronenstrom vom Metall Me zum n-Halbleiter n-HL möglich, was durch einen zurückgebogenen Pfeil symbolisiert ist.

Der Schottky-Kontakt SK weist somit eine gleichrichtende Wirkung auf, die zu der einer Schottky-Diode analog ist und durch die in Fig. 2d schematisch dargestellte Strom-Spannungs-Kennlinie I(U_{bias}) beschrieben wird.

Es ist erkennbar, dass im Durchlassbereich (U_{bias} positiv) der Strom I mit von null aus anwachsender Spannung U_{bias} zunächst nur langsam zunimmt, dann oberhalb eines Schwellwertes SW einen schnellen Anstieg zeigt und danach in einen linearen Verlauf übergeht. Der Schwellwert SW ergibt sich als Schnittpunkt des extrapolierten linearen Verlaufs mit der Abszisse.

Um eine Verbreiterung des Frequenzspektrums eines elektromagnetischen Signals zu erzielen, ist es daher notwendig, in den Bereich des Schottky-Kontakts SK ein elektromagnetisches Signal einzukoppeln, dessen elektrische Feldstärke zumindest ausreicht, um eine Spannung U_{bias} oberhalb der Schwellspannung zu erzeugen. Bevorzugt ist eine möglichst hohe elektrische Feldstärke. Im Falle einer Folge elektromagnetischer Bipolarpulse ist es zweckmäßig, diese Pulse mit möglichst hoher Feldstärke in den Schottky-Kontakt SK einzukoppeln. Der nichtlineare Verlauf der Kennlinie im Durchlassbereich trägt, wie auch experimentell nachgewiesen wurde (siehe Ausführungsbeispiel), wesentlich zur Verkürzung des ausgekoppelten Bipolarpulses 2 bei.

Sicherzustellen ist dabei lediglich, dass im Sperrbereich die (in diesem Fall negative) Spannung U_{bias} nicht die Durchbruchspannung erreicht, bei der der zunächst sehr geringe negative Sperrstrom (der in der Kennlinie I(U_{bias}), wie üblich, um den Faktor 10³ vergrößert dargestellt ist) abrupt ansteigt. Die im Sperrbereich umgekehrt gerichtete Feldstärke des eingekoppelten elektromagnetischen Signals, z. B. einer Folge elektromagnetischer Bipolarpulse 1, darf also einen (vom Fachmann in jedem Anwendungsfall leicht zu ermittelnden) Maximalwert nicht überschreiten.

Fig. 3 (zweckmäßigerweise neben Fig. 1 angeordnet) veranschaulicht in drei Grafiken noch einmal die Modifizierung eines elektromagnetischen Bipolarpulses 1, der den Bereich eines Schottky-Kontakts durchläuft.

Fig. 3a zeigt den zeitlichen Verlauf der elektrischen Feldstärke E(t) eines in den Bereich des Schottky-Kontakts eingekoppelten Bipolarpulses 1 und der dadurch erzeugten Bias-Spannung U_{bias}(t) am Schottky-Kontakt. Diese Bias-Spannung induziert einen Stromfluss I(t), der aufgrund der beschriebenen gleichrichtenden Wirkung des Schottky-Kontakts jedoch nur in einer Richtung möglich ist. Es resultiert somit ein unipolarer Strompuls 3, der im Gegensatz zum eingekoppelten Bipolarpuls 1 mit der zeitlichen Ausdehnung A-C nur eine zeitliche Ausdehnung A-B hat. Aufgrund der besonderen Form der in Fig. 2d dargestellten Kennlinie wird die Halbwertsbreite dieses unipolaren Strompulses 3 noch zusätzlich verringert. Fig. 3b zeigt den resultierenden unipolaren Strompuls 3, dessen Halbwertsbreite HWB₃ im Vergleich zur Halbwertsbreite HWB₁₊ des Abschnitts 1+ des Bipolarpulses 1 (Fig. 3a) verringert ist.

Gemäß den Maxwell'schen Gleichungen ruft der unipolare Strompuls 3 eine elektromagnetische Welle in Form eines Bipolarpulses mit verkürzter Pulsdauer hervor, die sich dem entlang des Schottky-Kontakts SK fortschreitenden gedämpften Bipolarpuls 1 überlagert. Daraus resultiert ein auf der gegenüberliegenden Seite des Schottky-Kontakts ausgekoppelter Bipolarpuls 2, dessen Pulsdauer τ₂ gegenüber der Pulsdauer τ₁ des Bipolarpulses 1 (Fig. 3a) verkürzt ist. Der Verlauf der elektrischen Feldstärke des Bipolarpulses 2 und seine Pulsdauer τ₂ sind in Fig. 3c schematisch dargestellt.

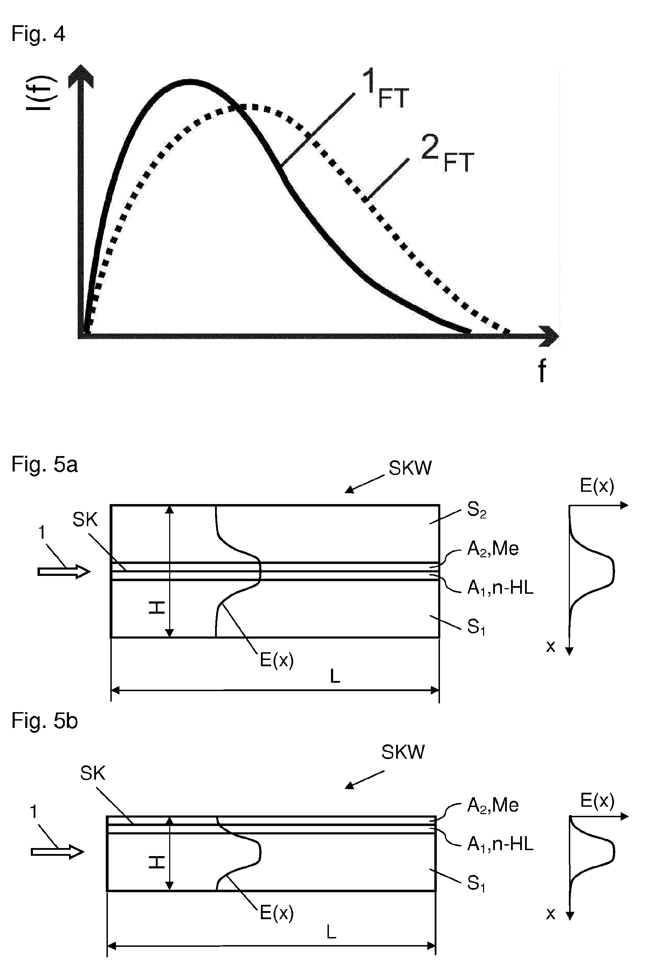

Die im Vergleich zur Pulsdauer τ₁ des Bipolarpulses 1 verkürzte Pulsdauer τ₂ des Bipolarpulses 2 bedingt eine Verbreiterung des Frequenzspektrums 2_{FT} des Bipolarpulses 2 gegenüber dem Frequenzspektrum 1_{FT} des Bipolarpulses 1, was durch eine FourierTransformation (FT) in den Frequenzbereich sichtbar wird. Diese Verbreiterung des Frequenzspektrums 2_{FT} ist in Fig. 4 schematisch dargestellt. Es ist erkennbar, dass diese Verbreiterung auf der hochfrequenten Seite des Frequenzspektrums 2_{FT} zu einer erheblichen Erhöhung seiner Intensität führt, sodass der für spektroskopische Untersuchungen verfügbare Messbereich zu höheren Frequenzen ausgedehnt wird. Besonders vorteilhaft ausnutzbar ist dieser Effekt im THz-Frequenzbereich, was im Ausführungsbeispiel näher erläutert wird.

### Ausführung eines erfindungsgemäßen Schottky-Kontakt-Wellenleiters SKW

Ein erfindungsgemäßer Schottky-Kontakt-Wellenleiter SKW mit einem Schottky-Kontakt SK wird realisiert, indem eine Schicht eines beliebigen n-dotierten Halbleiters n-HL mit einer Schicht eines beliebigen Metalls Me verbunden wird. Für die bevorzugten Anwendungen im THz-Bereich, die der Hochfrequenzelektronik zuzuordnen sind, sind für die Schicht des n-Halbleiters n-HL jedoch Verbindungshalbleiter zu bevorzugen. Es sind alle bekannten III/V- und II/VI-Verbindungshalbleiter verwendbar. Verwendbar sind auch Silizium, Germanium, SiGe sowie weitere dem Fachmann bekannte dotierte Halbleitermaterialien, die Ladungsträger mit hoher Beweglichkeit aufweisen. Ein besonders bevorzugtes Material ist Galliumarsenid GaAs, da es kostengünstig und umfassend charakterisiert ist. Für die Metallschicht Me sind die in gängigen mikroelektronischen Fertigungsprozessen verwendeten Metalle hoher Leitfähigkeit bevorzugt. Besonders bevorzugt ist Gold.

Die den Schottky-Kontakt bildenden Schichten (n-Halbleiter, Metall = aktive Schichten) müssen wesentlich dicker sein als die eigentliche Potenzialbarriere. Da die Dicke der Potenzialbarriere in der Größenordnung von 10 nm liegt, reicht für die aktiven Schichten eine Dicke von jeweils wenigen 100 nm aus.

Für die obere Grenze der Schichtdicke des n-Halbleiters n-HL besteht keine Beschränkung aus physikalischen Gründen. Es ist zweckmäßig, ihn einige 100 µm dick auszuführen, sodass er eine mechanische Stabilität erlangt. Geeignete Dicken liegen zwischen 200 µm und 1 mm. Noch größere Dicken sind aufgrund des erhöhten Materialaufwands nicht sinnvoll.

Für die obere Grenze der Schichtdicke des Metalls Me besteht hingegen eine Beschränkung aus physikalischen Gründen. Es ist notwendig, Reflexionen der in den Wellenleiter eingekoppelten elektromagnetischen Welle, z. B. eines Bipolarpulses 1, an den Oberflächen der Metallschicht Me zu verringern. Das wird erreicht, indem die Dicke der Metallschicht Me möglichst gering gewählt wird. Da die Metallschicht Me lediglich zur Ausbildung der Potenzialbarriere benötigt wird, reicht bereits eine Dicke von wenigen 10 nm aus. In jedem Fall ist eine Dicke der Metallschicht Me zu wählen, die wesentlich geringer ist als die halbe Wellenlänge des in den SKW eingekoppelten elektromagnetischen Signals. Für Anwendungen im THz-Bereich, wo die Wellenlänge selbst am kurzwelligen Ende (bei 10 THz) noch λ = 30 µm beträgt, ist stets eine Dicke der Metallschicht Me in der Größenordnung von 1 µm geeignet. Soll der erfindungsgemäße SKW im optischen Bereich (vom IR- bis hin zum UV-Bereich) eingesetzt werden, so ist, unter Beachtung der jeweiligen Wellenlänge, eine geringere Dicke der Metallschicht Me zu wählen.

Ein unter Berücksichtigung dieser Randbedingungen hergestellter Schottky-Kontakt-Wellenleiter SKW, aufweisend eine n-Halbleiterschicht n-HL und eine Metallschicht Me, zeigt bereits die erfindungsgemäße Funktionalität. Hergestellt wird er zweckmäßigerweise, indem die n-Halbleiterschicht n-HL, vorzugsweise aus einem kommerziell erhältlichen Substrat geschnitten, mit der so dünn wie möglich gewählten Metallschicht Me bedampft wird. Es resultiert ein Schottky-Kontakt-Wellenleiter SKW mit einer stark asymmetrischen Wellenleitergeometrie (Dicke der n-Halbleiterschicht in der Größenordnung von 100 µm, Dicke der Metallschicht in der Größenordnung von 1 µm oder geringer).

Ein solcher Schottky-Kontakt-Wellenleiter SKW mit stark asymmetrischer Wellenleitergeometrie weist den Nachteil auf, dass die Einkopplung einer elektromagnetischen Welle in den Wellenleiter derart, dass in der Ebene des Schottky-Kontakts SK eine maximale elektrische Feldstärke erzielt wird, äußerst schwierig und zudem aufgrund unerwünschter Dispersion sehr nachteilig ist. Das wird unten noch näher erläutert und in Fig. 5 veranschaulicht.

Eine Möglichkeit, diesen Nachteil zu beseitigen, besteht darin, die freiliegende Metallschicht Me des Schottky-Kontakt-Wellenleiters SKW dichtschließend, d. h. ohne einen Zwischenraum (Luftspalt, Vakuum), mit einem dielektrischen Substrat abzudecken, das den gleichen oder zumindest einen ähnlichen Brechungsindex wie die n-Halbleiterschicht n-HL aufweist. Besteht die n-Halbleiterschicht aus n-GaAs, so wird als Abdeckung idealerweise ein Substrat aus dem gleichen intrinsischen Halbleiter i-HL, hier also intrinsischem GaAs (i-GaAs) gleicher Dicke, gewählt. Bei Verwendung des SKW im THz-Frequenzbereich ist es aber auch möglich, ein Saphir-Substrat als Abdeckung zu verwenden, da die Brechungsindizes von GaAs (n ≈ 3,5) und Saphir (n = 3,4) in diesem Frequenzbereich sehr gut übereinstimmen. Andere dielektrische Materialien sind als Abdeckung verwendbar, sofern ihr Brechungsindex um nicht mehr als 0,6, vorzugsweise um nicht mehr als 0,4, vom Brechungsindex des n-Halbleiters n-HL abweicht.

Um die gewünschte dichtschließende Abdeckung zu realisieren, sollten die in Kontakt zu bringenden Oberflächen eben sein und eine sehr geringe Rauigkeit aufweisen. Substrate für mikroelektronische Anwendungen erfüllen diese Anforderung in idealer Weise. Vorzugsweise wird die Abdeckung zusätzlich mechanisch angepresst.

Der resultierende Schottky-Kontakt-Wellenleiter SKW mit der Schichtfolge n-HL/Me/i-HL (oder statt i-HL einem anderen geeigneten Material) zeigt die erfindungsgemäße Funktionalität und erlaubt es aufgrund seiner symmetrischen Wellenleitergeometrie, eine elektromagnetische Welle, z. B. einen Bipolarpuls 1, so einzukoppeln, dass in der Ebene des Schottky-Kontakts SK eine maximale elektrische Feldstärke erzielt wird.

Bei der Einkopplung ist hier, wie auch in allen anderen Anwendungsfällen, zu beachten, dass der elektrische Feldvektor der eingekoppelten elektromagnetischen Welle zumindest eine senkrecht zur Ebene des Schottky-Kontakts stehende Komponente (> 0) aufweisen muss. Vorzugsweise erfolgt die Einkopplung so, dass der elektrische Feldvektor der eingekoppelten elektromagnetischen Welle senkrecht zur Ebene des Schottky-Kontakts steht, denn jede andere Orientierung ist mit einer unnötigen Abschwächung der erwünschten Verbreiterung des Frequenzspektrums verbunden.

In einer weiteren zweckmäßigen Ausführungsform wird der Schottky-Kontakt-Wellenleiter SKW so ausgeführt, dass beide aktiven Schichten, also nicht nur die Metallschicht Me, sondern auch die n-Halbleiterschicht n-HL, sehr dünn sind und eine annähernd gleiche Dicke (in der Größenordnung 1 µm) aufweisen.

Dazu weist der Schottky-Kontakt-Wellenleiter beidseitig zur Anordnung der aktiven Schichten n-HL, Me jeweils ein direkt benachbartes ebenes Substrat auf. Ein erstes Substrat S₁ ist der Schicht des n-Halbleiters n-HL benachbart, während ein zweites Substrat S₂ der Metallschicht Me benachbart ist. Wie im unten folgenden Ausführungsbeispiel näher beschrieben wird, ist es zweckmäßig, beide aktiven Schichten nacheinander (zuerst n-HL, dann Me) auf dem Substrat S₁ abzuscheiden, sodass dieses als Träger der Anordnung der aktiven Schichten dient, während das Substrat S₂ mit der Anordnung verbunden wird, indem es auf die freiliegende Oberfläche der Metallschicht Me aufgelegt und ggf. mechanisch angepresst wird.

Als Substrat S₁ wird dasselbe Halbleiter-Basismaterial wie in der aktiven n-Halbleiterschicht n-HL eingesetzt, jedoch intrinsisch, (i-Halbleiter i-HL). Es kann z. B. als rechteckiges Substrat mit geeignet gewählten Abmessungen aus einem kommerziell verfügbaren Halbleiterwafer vereinzelt werden. Durch die Dicke dieses Halbleiterwafers, die im Bereich einiger 100 µm liegt, wird die Dicke des Substrats S₁ vorgegeben. Ein Halbleiterwafer reicht in der Regel aus, um daraus eine Vielzahl solcher identischen Substrate zu vereinzeln.

Das Substrat S₂ wird bevorzugt identisch zum Substrat S₁ ausgeführt (gleiches Material, somit gleicher Brechungsindex). Alternativ kann für das Substrat S₂ auch ein anderes dielektrisches Material verwendet werden, das einen ähnlichen Brechungsindex (gemäß den o. g. Bedingungen) aufweist. Wird für das Substrat S₁ i-GaAs verwendet, so ist für das Substrat S₂ neben i-GaAs wiederum auch Saphir geeignet.

Die so erhaltene Schichtfolge bildet einen Schottky-Kontakt-Wellenleiter SKW mit einer symmetrischen Wellenleitergeometrie in Form einer Sandwichstruktur: Zwischen den deckungsgleich übereinander angeordneten Substraten S₁ und S₂, die jeweils eine Dicke von einigen 100 µm haben, befinden sich die wesentlich dünneren, den Schottky-Kontakt SK bildenden aktiven Schichten: eine n-Halbleiterschicht n-HL, benachbart zum Substrat S₁ (i-Halbleiter), und eine Metallschicht Me, benachbart zum Substrat S₂ (i-Halbleiter identisch zu S₁ oder anderes dielektrisches Material). Bei Verwendung rechteckiger Substrate erhält der Schottky-Kontakt-Wellenleiter SKW somit die Form eines flachen Quaders, dessen Höhe H durch die summierte Dicke der beiden Substrate S₁ und S₂ gegeben ist (bei Vernachlässigung der sehr geringen Dicke der aktiven Schichten). Länge L, Höhe H und Breite des Wellenleiters werden gemäß dem Frequenzbereich gewählt, in welchem der Wellenleiter eingesetzt werden soll. Die Länge L ist so zu wählen, dass der Wellenleiter im vorgesehenen Wellenlängenbereich eine hinreichend große Transmission aufweist. Die Höhe H des Wellenleiters bestimmt seine untere Abschneidefrequenz. Alle niederfrequenten Anteile, bei denen die halbe Wellenlänge größer ist als die Höhe H des Wellenleiters, werden unterdrückt. Dickere Substrate bewirken eine Verringerung der unteren Abschneidefrequenz, sind jedoch teurer. Die Breite des Wellenleiters ist größer als oder gleich seiner Höhe H zu wählen, unterliegt aber keinen sonstigen Einschränkungen. Wird die Breite des Wellenleiters kleiner als seine Höhe H gewählt, so bewirkt sie eine unerwünschte Erhöhung der unteren Abschneidefrequenz. Der Fachmann ist unter Berücksichtigung dieser Hinweise in der Lage, geeignete Abmessungen des Schottky-Kontakt-Wellenleiters für jeden Frequenzbereich zu bestimmen.

Die Vorteile einer symmetrischen Wellenleitergeometrie, hier realisiert durch die Verwendung zweier Substrate S₁ und S₂, werden durch Fig. 5a und Fig. 5b verdeutlicht. Beide Figuren zeigen Schnitte durch Schottky-Kontakt-Wellenleiter SKW.

Fig. 5a zeigt den erfindungsgemäßen SKW mit einer symmetrischen Wellengeometrie mit zwei Substraten S₁ und S₂, die beidseitig benachbart zur Anordnung der aktiven Schichten n-HL und Me positioniert sind. Dieser SKW erlaubt es, ein elektromagnetisches Signal, z. B. einen Bipolarpuls 1 (hier vereinfacht als Pfeil dargestellt), zuverlässig so einzukoppeln, dass eine maximale Feldstärke E(x) in die Ebene des Schottky-Kontakts SK eingekoppelt wird, wodurch eine maximale Bias-Spannung U_{bias} am Schottky-Kontakt SK erreicht wird. Die gleichrichtende Wirkung des Schottky-Kontakts SK und somit auch die gewünschte Verbreiterung des Frequenzspektrums des elektromagnetischen Signals werden maximiert. (Die Ebene des Schottky-Kontakts ist, wie in Fig. 1 definiert, die y-z-Ebene. Die Koordinatenrichtung x steht senkrecht auf der Ebene des Schottky-Kontakts.)

Fig. 5b zeigt dagegen einen SKW mit nur einem Substrat S₁, also einer asymmetrischen Wellenleitergeometrie, bei der die Anordnung der aktiven Schichten auf einer Seite direkt in Kontakt mit dem umgebenden Medium (Luft) oder ggf. einem Vakuum steht. Würde ein elektromagnetisches Signal hier in die Ebene der aktiven Schichten eingekoppelt, so würde sich ein Teil des Signals in einem Medium mit einem Brechungsindex n nahe oder gleich 1 (Luft, Vakuum) ausbreiten, ein anderer Teil des Signals jedoch im Substrat S₁ mit einem sehr viel höheren Brechungsindex, z. B. n ≈ 3,5 im Falle von GaAs. Das Signal würde somit einer sehr starken Dispersion ausgesetzt und dadurch unzulässig verformt. Bei dieser Anordnung ist es somit nicht möglich, ein elektromagnetisches Signal, z. B. einen Bipolarpuls 1, so einzukoppeln, dass eine maximale Feldstärke E in die Ebene des Schottky-Kontakts SK eingekoppelt wird. Im Bereich des Schottky-Kontakts SK wird in diesem Fall nur eine sehr geringe Bias-Spannung U_{bias} erzielt. Die gewünschte Verbreiterung des Frequenzspektrums des elektromagnetischen Signals ist nur schwach ausgeprägt, sie ist für praktische Anwendungen unzureichend.

Selbstverständlich ist der in Fig. 5a und Fig. 5b direkt in den SKW eingezeichnete Feldstärkeverlauf E(x) nicht als Bestandteil des SKW fehlzudeuten. Der Verlauf E(x) ist rechts jeweils noch einmal schematisch dargestellt.

Die Wellenleitergeometrie des Schottky-Kontakt-Wellenleiters SKW ist nicht auf eine Quaderform beschränkt. Aufgrund der bevorzugten Verwendung ebener Substrate aus der Halbleitertechnik sind quaderförmige Wellenleiter jedoch am einfachsten herstellbar und daher bevorzugt.

Die Ein- und Auskopplung der elektromagnetischen Signale in den/aus dem SKW kann sowohl im Freistrahl als auch fasergekoppelt erfolgen. Dabei sind auch Kombinationen möglich, d. h. Einkopplung über eine Faser, Auskopplung im Freistrahl oder umgekehrt.

### Ausführungsbeispiel

### Herstellung eines Schottky-Kontakt-Wellenleiters für den THz-Frequenzbereich und experimenteller Nachweis seiner Eignung zur Verbreiterung des Frequenzspektrums eines THz-Signals

Der Schottky-Kontakt-Wellenleiter soll es ermöglichen, das Frequenzspektrum eines von einer THz-Quelle emittierten Signals zu verbreitern. Die Verbreiterung eines Frequenzspektrums wird nachfolgend kurz als Frequenzverbreiterung bezeichnet. Sie soll in diesem Ausführungsbeispiel vor allem im Bereich oberhalb von 1 THz wirksam sein.

### Herstellung des Schottky-Kontakt-Wellenleiters SKW

Aus einem kommerziell verfügbaren i-GaAs-Wafer der Dicke 0,41 mm werden zwei identische, rechteckige Substrate S₁ und S₂ mit einer Länge L = 7,3 mm und einer Breite B = 4,4 mm vereinzelt. Das Substrat S₁ wird epitaktisch mit einer n-GaAs-Schicht der Dicke 1100 nm, die eine Ladungsträgerkonzentration von 2,4 · 10¹⁶ cm⁻³ aufweist, gewachsen. Die n-GaAs-Schicht wird danach mit einer Goldschicht der Dicke 700 nm bedampft. Das Substrat S₂ wird deckungsgleich auf die Goldschicht aufgelegt und mechanisch angepresst. Die resultierende Anordnung der Höhe H = 0,82 mm bildet einen SKW mit einem flächenhaften Schottky-Kontakt SK in der Grenzfläche zwischen der n-GaAs-Schicht und der Goldschicht.

### Herstellung eines Test-Wellenleiters TW ohne Schottky-Kontakt

Hergestellt wird außerdem ein Test-Wellenleiter TW, der keine Goldschicht aufweist, im Übrigen aber einen mit der vorab beschriebenen Anordnung identischen Aufbau und identische Abmessungen hat. Dieser Test-Wellenleiter besteht somit aus zwei Substraten S₁ und S₂, zwischen denen sich eine n-Halbleiterschicht n-HL befindet. Er enthält zwei i-GaAs/n-GaAs-Übergänge, weist jedoch wegen des Fehlens einer Metallschicht keinen Schottky-Kontakt auf.

### Herstellung eines Referenz-Wellenleiters RW

Schließlich wird ein Referenz-Wellenleiter RW hergestellt, der lediglich aus zwei i-GaAs-Substraten S₁ und S₂ besteht, die deckungsgleich übereinandergelegt und mechanisch zusammengepresst werden. Die Substrate haben die gleichen Abmessungen wie die Substrate der anderen beiden Wellenleiter.

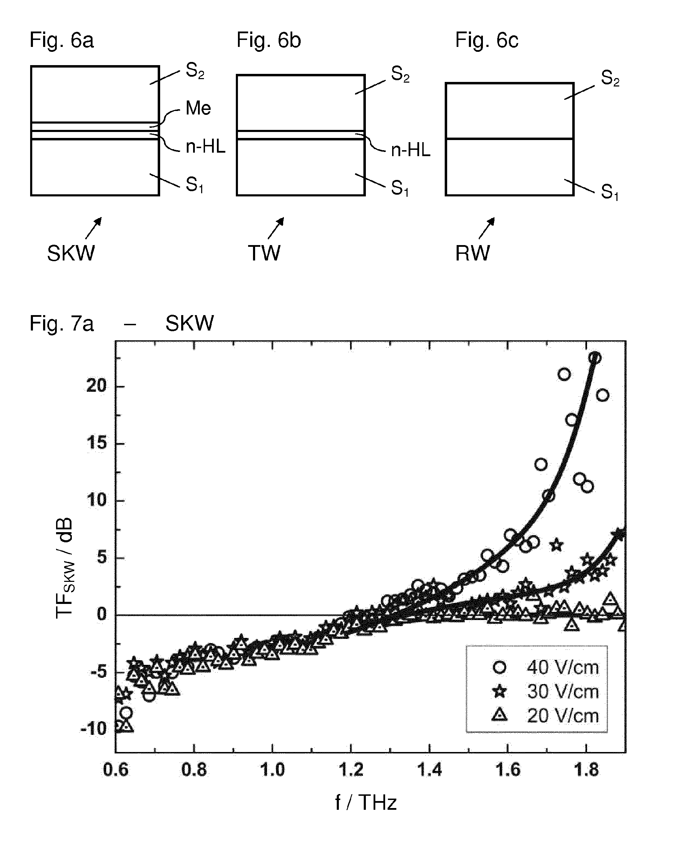

Fig. 6a, 6b und 6c zeigen schematische Darstellungen der Schichtfolgen der drei Wellenleiter. Zum Zwecke der Visualisierung sind die in der Realität extrem dünnen aktiven Schichten (n-Halbleiterschicht n-HL und Metallschicht Me) übertrieben dick dargestellt.

### Experimenteller Nachweis der Frequenzverbreiterung am SKW

Um einen überzeugenden experimentellen Nachweis der Frequenzverbreiterung am Schottky-Kontakt-Wellenleiter SKW zu führen, werden nacheinander der Referenz-Wellenleiter RW, der Test-Wellenleiter TW und der Schottky-Kontakt-Wellenleiter SKW mit identischen THz-Signalen (hier Bipolarpulsen 1) beaufschlagt, deren elektrische Feldstärke stufenweise erhöht wird. Die THz-Signale werden in die Ebene der aktiven Schichten (n-Halbleiterschicht, Metallschicht) bzw., im Falle des Referenz-Wellenleiters, in die Ebene zwischen den beiden Substraten S₁ und S₂ eingekoppelt, wobei ihr elektrischer Feldvektor senkrecht zu dieser Ebene gerichtet ist. Aufgrund der symmetrischen Wellenleitergeometrie mit zwei Substraten ist die Einkopplung mit maximaler elektrischer Feldstärke in die Mitte des Wellenleiters, wo die aktiven Schichten bzw. die Grenzfläche zwischen den beiden Substraten positioniert sind, problemlos möglich. Die maximale elektrische Feldstärke der hier im Freistrahl eingekoppelten Bipolarpulse 1 wird in den Stufen E =20 V/cm, E = 30 V/cm und E = 40 V/cm gewählt.

Für jede dieser Feldstärken wird das aus den Wellenleitern (RW, TW, SKW) ausgekoppelte THz-Signal (entsprechend den Bipolarpulsen 2) gemessen. Es wird eine Transferfunktion für den Test-Wellenleiter TW ermittelt, indem das Frequenzspektrum des aus dem Test-Wellenleiter TW ausgekoppelten Signals durch das Frequenzspektrum des aus dem Referenz-Wellenleiter RW auskoppelten Signals dividiert wird. In analoger Weise wird eine Transferfunktion für den Schottky-Kontakt-Wellenleiter SKW ermittelt. Das aus dem Referenz-Wellenleiter RW auskoppelte Signal dient somit als Referenz für die Messungen an den beiden anderen Wellenleitern.

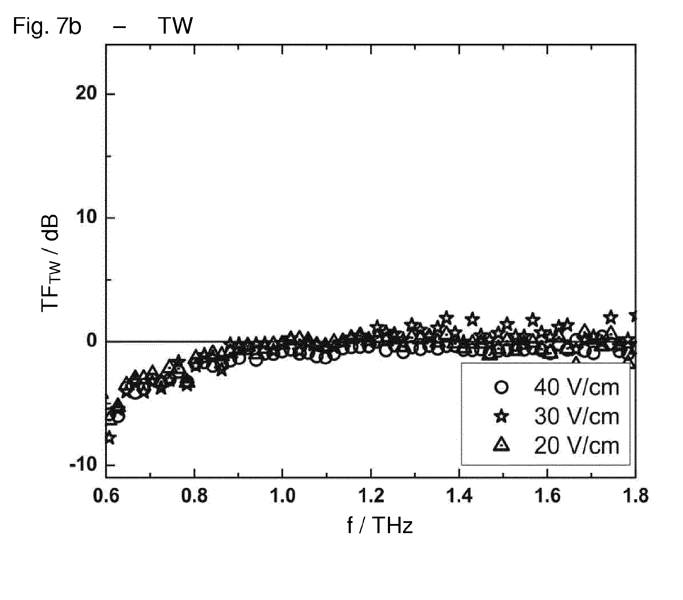

Fig. 7a und 7b zeigen, für die drei gewählten Feldstärken, die Transferfunktionen des Schottky-Kontakt-Wellenleiters SKW und des Test-Wellenleiters TW. Zweckmäßigerweise wurden die Transferfunktionen in eine Dezibel-Skale umgerechnet.

Fig. 7a zeigt, dass die Transferfunktionen TF_{SKW} des Schottky-Kontakt-Wellenleiters SKW oberhalb einer Frequenz von f = 1,2 THz eine klare Abhängigkeit von der elektrischen Feldstärke E aufweisen.

Bei einer Feldstärke von E = 20 V/cm zeigt die Transferfunktion einen konstanten Verlauf bei 0 dB. Der Schottky-Kontakt-Wellenleiter SKW zeigt bei dieser Feldstärke dasselbe Übertragungsverhalten wie der Referenz-Wellenleiter RW, ein Anstieg in den positiven Bereich, der einer Frequenzverbreiterung entsprechen würde, ist bei dieser geringen Feldstärke noch nicht nachweisbar. Erklärbar ist dieses Verhalten dadurch, dass bei dieser niedrigen Feldstärke die Spannung U_{bias} am Schottky-Kontakt unterhalb des Schwellwerts SW bleibt, sodass nur ein vernachlässigbar geringer Stromfluss erfolgt.

Bei einer Feldstärke von E = 30 V/cm zeigt die Transferfunktion oberhalb von f = 1,2 THz, ausgehend von 0 dB, einen ansteigenden Verlauf, verdeutlicht durch eine Ausgleichskurve, und erreicht bei f = 1,8 THz einen Wert von ca. 4 dB, was einer Intensitätserhöhung um einen Faktor 2,5 entspricht. Somit ist im Frequenzbereich oberhalb von 1,2 THz eine eindeutige Signalerhöhung nachweisbar, die auf die erfindungsgemäße Frequenzverbreiterung zurückzuführen ist.

Bei einer Feldstärke von E = 40 V/cm zeigt sich die Frequenzverbreiterung in einer drastisch stärkeren Ausprägung. Die Transferfunktion hat hier, ausgehend von 0 dB bei f = 1,2 THz, einen stark ansteigenden Verlauf und erreicht bei f = 1,8 THz einen Wert von ca. 20 dB, was einer Intensitätserhöhung um einen Faktor 100 entspricht. Die erfindungsgemäße Frequenzverbreiterung kommt hier voll zum Tragen. Die Messungen bei den verschiedenen Feldstärken bestätigen zudem, dass die Frequenzverbreiterung mit der Feldstärke skaliert. Es ist offensichtlich, dass die Frequenzverbreiterung bei noch höheren Feldstärken (E > 40 V/cm) noch stärker ausgeprägt sein wird, jedoch konnte dieser Feldstärkebereich, bedingt durch die Grenzen des weiter unten beschriebenen Equipments, experimentell noch nicht untersucht werden.

Um einen eindeutigen experimentellen Beweis zu führen, dass die beobachtete Frequenzverbreiterung durch den Schottky-Kontakt des Schottky-Kontakt-Wellenleiters hervorgerufen wird, werden die unter den gleichen Messbedingungen gewonnenen Transferfunktionen des Test-Wellenleiters herangezogen.

Fig. 7b zeigt, dass die Transferfunktionen TF_{TW} des Test-Wellenleiters TW einen nahezu identischen Verlauf zeigen, der unabhängig von der gewählten Feldstärke E ist. Im hochfrequenten Bereich (oberhalb von 1,2 THz weisen die Transferfunktionen einen konstanten Verlauf bei 0 dB auf, der Test-Wellenleiter TW zeigt somit in diesem Bereich dasselbe Übertragungsverhalten wie der Referenz-Wellenleiter RW, ein Anstieg in den positiven Bereich, der einer Frequenzverbreiterung entsprechen würde, ist nicht nachweisbar. Das entspricht dem erwarteten Verhalten: Da der Test-Wellenleiter keinen Schottky-Kontakt und auch keinen anderen Übergang mit elektrisch gleichrichtender Wirkung aufweist, wird keine Frequenzverbreiterung beobachtet.

Somit ist experimentell zweifelsfrei nachgewiesen, dass die in den Transferfunktionen des Schottky-Kontakt-Wellenleiters SKW erkennbare Frequenzverbreiterung eindeutig auf die gleichrichtende Wirkung des Schottky-Kontakts zurückzuführen ist. Aufgrund der mit der Frequenzverbreiterung verbundenen Signalverstärkung wird der Frequenzbereich zwischen 1,2 THz und 1,8 THz für spektroskopische Untersuchungen zugänglich, da die erforderlichen Messzeiten um bis zu zwei Größenordnungen verkürzt werden.

Es sei noch kurz auf den Frequenzbereich unterhalb von 1,2 THz eingegangen. Hier zeigen die Transferfunktionen des Schottky-Kontakt-Wellenleiters und des Test-Wellenleiters einen nahezu identischen, zu niedrigen Frequenzen hin immer schneller abfallenden Verlauf, der zudem nahezu unabhängig von der Feldstärke E ist. Bei ca. 0,6 THz verstärkt sich dieser abfallende Verlauf, was durch die untere Abschneidefrequenz des Schottky-Kontakt-Wellenleiters bedingt ist, die aufgrund seiner geometrischen Dimensionierung gerade bei 0,6 THz liegt.

Dieser Intensitätsverlust ist hier unproblematisch, denn das Ziel, die obere Grenze des nutzbaren Frequenzbereichs zu steigern, wurde realisiert. Durch Änderung der Geometrie, d. h. die Verwendung dickerer Substrate, könnte die untere Abschneidefrequenz verringert werden.

Zur Durchführung der vorab beschriebenen Experimente wird ein dem Fachmann bekanntes Equipment eingesetzt, das zum Zwecke der vollständigen Offenbarung hier genannt werden soll:

Die THz-Bipolarpulse 1 werden durch eine photoleitende Antenne vom Typ Tera-SED3 (Fa. Laser Quantum) erzeugt, welche mit kurzen infraroten Laserpulsen (Pulsenergie 1 nJ, Wellenlänge 800 nm, Pulsdauer 100 fs, Pulswiederholrate 80 MHz) beaufschlagt wird.

Die elektrische Feldstärke der von der photoleitenden Antenne emittierten THz-Bipolarpulse 1 wird eingestellt, indem die Vorspannung dieser Antenne variiert wird. Ihre Vorspannung ist zwischen 15 V und 27,5 V durchstimmbar. Die nach oben begrenzte Vorspannung begrenzt die im durchgeführten Experiment erreichbare maximale Feldstärke der THz-Bipolarpulse 1 auf 40 V/cm.

Die THz-Feldstärke der eingekoppelten Bipolarpulse 1 wird mit einer kalibrierten Golay-Zelle (Fa. Tydex) gemessen. Die THz-Feldstärke der ausgekoppelten Bipolarpulse 2 wird mittels elektrooptischem Sampling unter Verwendung zweier Photodioden gemessen.

Die in dieser Patentanmeldung dargestellte Erfindung ist, wie bereits erwähnt, nicht auf den in der Beschreibung und im Ausführungsbeispiel besonders hervorgehobenen THz-Frequenzbereich beschränkt. Vielmehr kann sie ohne Weiteres auf andere Frequenzbereiche übertragen werden, indem die Abmessungen des Wellenleiters an die jeweils gewünschte Wellenlänge angepasst werden.

Soll beispielsweise ein SKW zur Frequenzverbreiterung im Radiowellenbereich, z. B. für eine Frequenz von 900 MHz bereitgestellt werden, so muss dieser SKW eine Höhe und Breite von mindestens 33,3 cm aufweisen. Unter Anwendung der Beziehung λ · f = c kann der Fachmann die optimalen Anmessungen des erfindungsgemäßen Wellenleiters für jeden Anwendungsfall ermitteln und die Erfindung somit für jeden gewünschten Frequenzbereich adaptieren.

Ferner ist, wie ebenfalls bereits erwähnt, die Erfindung nicht auf Wellenleiter mit einem Me/n-HL-Schottky-Kontakt beschränkt. Es können Wellenleiter mit beliebigen elektrisch gleichrichtenden Übergängen verwendet werden, insb. ein Wellenleiter mit einem Me/p-HL-Schottky-Kontakt sowie ein Wellenleiter mit einem als p-n-Übergang ausgebildeten Kontakt.

Ein Wellenleiter mit p-n-Übergang ist ausführbar einerseits mit dicken aktiven Schichten, indem ein p-dotiertes Substrat und ein n-dotiertes Substrat, jeweils einige 100 µm dick, in Kontakt gebracht werden. Andererseits ist er ausführbar mit dünnen aktiven Schichten (p-Halbleiter und n-Halbleiter, mit einer Dicke in der Größenordnung von jeweils 1 µm), die auf intrinsischen Halbleitersubstraten aus demselben Basismaterial gewachsen werden.

Schottky-Kontakt-Wellenleiter sind jedoch bevorzugt, da Schottky-Übergänge ein besonders schnelles Schaltverhalten zeigen und in Durchlassrichtung hohe Stromflüsse zulassen.

Auch hinsichtlich der Substrate stehen dem Fachmann Spielräume zur Verfügung. So können die aktiven Schichten statt auf intrinsische Halbleitersubstrate beispielsweise auch auf kostengünstige Glassubstrate aufgebracht werden. Ein intrisisches Halbleitersubstrat ist aber bevorzugt, wenn die aktive Halbleiterschicht durch Epitaxie aufgebracht wird.

Mit der Erfindung werden somit erstmals ein Verfahren und ein Bauelement bereitgestellt, die es erlauben, das Frequenzspektrum elektromagnetischer Wellen unabhängig von deren Emitter zu verbreitern. Das Bauelement kann in alle Vorrichtungen eingebaut werden, in denen eine solche Frequenzverbreiterung erwünscht ist.

Das erfindungsgemäße Bauelement stellt eine sehr kostengünstige Alternative zu anderen Möglichkeiten der Frequenzverbreiterung dar. In der Optoelektronik erlaubt es den Verzicht auf neue Antennen und einen veränderten Aufbau. In der THz-Technologie erlaubt es den Verzicht auf leistungsstärkere Lasersysteme, die sehr kostspielig und wartungsintensiv sind.

### Abbildungslegenden

Fig. 1: Schnittdarstellung eines Schottky-Kontakts SK, ausgebildet zwischen einer Metallschicht Me und einer Schicht eines n-dotierten Halbleiters n-HL, mit einem in den Schottky-Kontakt SK eingekoppelten Bipolarpuls 1 sowie einem am gegenüberliegenden Ende des Schottky-Kontakts SK ausgekoppelten Bipolarpuls 2.
Fig. 2a: Zeitlicher Verlauf der elektrischen Feldstärke E(t) eines in den Schottky-Kontakt SK eingekoppelten Bipolarpulses 1.
Fig. 2b: Abschnitt 1+ des Bipolarpulses 1, der am Schottky-Kontakt SK eine Vorspannung in Durchlassrichtung erzeugt, und zugehöriges Bänderschema.
Fig. 2c: Abschnitt 1- des Bipolarpulses 1, der am Schottky-Kontakt SK eine Vorspannung in Sperrrichtung erzeugt, und zugehöriges Bänderschema.
Fig. 2d: Schematische Darstellung der Strom-Spannungs-Kennlinie I(U_{bias}) eines Schottky-Kontakts SK.
Fig. 3a: Zeitlicher Verlauf der elektrischen Feldstärke E(t) eines in den Bereich des Schottky-Kontakts eingekoppelten Bipolarpulses 1 und der dadurch erzeugten Bias-Spannung U_{bias}(t) am Schottky-Kontakt.
Fig. 3b: Zeitlicher Verlauf des unipolaren Strompulses 3.
Fig. 3c: Zeitlicher Verlauf der elektrischen Feldstärke E(t) eines aus dem Bereich des Schottky-Kontakts ausgekoppelten Bipolarpulses 2.
Fig. 4: Schematische Darstellung der Frequenzspektren 1_{FT} und 2_{FT} von Bipolarpulsen 1 und 2.
Fig. 5a: Schottky-Kontakt-Wellenleiter SKW mit einer symmetrischen Wellengeometrie.
Fig. 5b: Schottky-Kontakt-Wellenleiter SKW mit einer asymmetrischen Wellengeometrie.
Fig. 6a:Schematische Darstellung der Schichtfolge eines Schottky-Kontakt-Wellenleiters SKW.
Fig. 6b:Schematische Darstellung der Schichtfolge eines Test-Wellenleiters TW.
Fig. 6c:Schematische Darstellung der Schichtfolge eines Referenz-Wellenleiters RW.
Fig. 7a: Experimentell gemessene Transferfunktionen TF_{SKW} des Schottky-Kontakt-Wellenleiters SKW für drei verschiedene elektrische Feldstärken.
Fig. 7b: Experimentell gemessene Transferfunktionen TF_{TW} des Test-Wellenleiters TW für drei verschiedene elektrische Feldstärken.

### Liste der Bezugszeichen und Formelzeichen

- A₁, A₂: - aktive Schichten
- F: - Grenzfläche mit gleichrichtender Wirkung, z. B. ein Schottky-Kontakt SK
- SK: - Schottky-Kontakt
- SKW: - Schottky-Kontakt-Wellenleiter
- TW: - Test-Wellenleiter
- RW: - Referenz-Wellenleiter
- TF_{SKW}: - Transferfunktionen des Schottky-Kontakt-Wellenleiters
- TF_{TW}: - Transferfunktionen des Test-Wellenleiters
- Me: - Metall
- i-HL: - intrinsischer Halbleiter
- n-HL: - n-dotierter Halbleiter
- p-HL: - p-dotierter Halbleiter
- L, H: - Länge und Höhe des SKW
- 1: - in den SKW eingekoppelte elektromagnetische Welle, bevorzugt ein Bipolarpuls mit den Pulsabschnitten 1+ und 1-
- 1+: - Pulsabschnitt, der eine Vorspannung in Durchlassrichtung erzeugt
- 1-: - Pulsabschnitt, der eine Vorspannung in Sperrrichtung erzeugt
- A, B: - Grenzen des Pulsabschnitts 1+
- B, C: - Grenzen des Pulsabschnitts 1-
- M+: - Maximum des elektrischen Feldes E(t)
- M-: - Minimum des elektrischen Feldes E(t)
- 2: - aus dem SKW ausgekoppelte elektromagnetische Welle, bevorzugt ein Bipolarpuls
- 3: - unipolarer Strompuls
- HWB₁₊: - Halbwertsbreite des Pulsabschnitts 1+
- HWB₃: - Halbwertsbreite des unipolaren Strompulses 3
- I(t): - Verlauf des unipolaren Strompulses 3 als Funktion der Zeit t
- S₁: - erstes Substrat
- S₂: - zweites Substrat
- E(t): - elektrisches Feld des eingekoppelten Bipolarpulses 1 als Funktion der Zeit t
- U_{bias}(t): - durch das elektrische Feld E(t) am SK erzeugte Bias-Spannung als Funktion der Zeit t
- SW: - Schwellwert der Bias-Spannung in der Kennlinie I(U_{bias})
- c: - Lichtgeschwindigkeit
- f: - Frequenz
- f₁, f₂: - Ausgangsfrequenzen für Mischung (nur im Stand der Technik verwendet)
- λ: - Wellenlänge
- t: - Zeit
- τ: - Pulsdauer allgemein (nur im Stand der Technik verwendet)
- τ₁: - Pulsdauer eines Bipolarpulses 1
- τ₂: - Pulsdauer eines Bipolarpulses 2

## Patentansprüche

1. Verfahren zur Verbreiterung eines Frequenzspektrums einer elektromagnetischen Welle, **dadurch gekennzeichnet, dass** eine elektromagnetische Welle (1) in eine, durch den Kontakt zweier benachbarter aktiver Schichten (A1, A2) gebildete, Grenzfläche (F) mit elektrisch gleichrichtender Wirkung, eingekoppelt wird, entlang dieser Grenzfläche (F) fortschreitet, wobei sie einen unipolaren Strompuls (3) induziert, welcher einen Bipolarpuls mit verkürzter Pulsdauer erzeugt, der sich der eingekoppelten elektromagnetischen Welle überlagert, und eine durch die Überlagerung gebildete elektromagnetische Welle (2), aufweisend ein im Vergleich zur eingekoppelten elektromagnetischen Welle (1) verbreitertes Frequenzspektrum, aus der Grenzfläche (F) ausgekoppelt wird.

2. Verfahren nach Anspruch 1, **dadurch gekennzeichnet, dass** die in die Grenzfläche (F) eingekoppelte elektromagnetische Welle ein gepulstes Signal, bevorzugt eine Folge elektromagnetischer Bipolarpulse (1), ist.

3. Verfahren nach Anspruch 1, **dadurch gekennzeichnet, dass** die in die Grenzfläche (F) eingekoppelte elektromagnetische Welle (1) ein kontinuierliches Signal ist.

4. Verfahren nach einem der Ansprüche 1, 2 oder 3 **dadurch gekennzeichnet, dass** die Einkopplung der elektromagnetischen Welle in die Grenzfläche (F) und die Auskopplung der durch Überlagerung gebildeten elektromagnetischen Welle (2) aus der Grenzfläche (F) wahlweise im Freistrahl oder fasergekoppelt erfolgen.

5. Verfahren nach einem der Ansprüche 1 bis 4, **dadurch gekennzeichnet, dass** die in die Grenzfläche (F) eingekoppelte elektromagnetische Welle (1) eine maximale elektrische Feldstärke von E > 20 V/cm, bevorzugt E > 30 V/cm und besonders bevorzugt E > 40 V/cm aufweist.

6. Bauelement, ausgeführt als Wellenleiter, geeignet zur Durchführung eines Verfahrens nach einem der Ansprüche 1 bis 5, **dadurch gekennzeichnet, dass** es eine Anordnung zweier benachbarter aktiver Schichten (A₁, A₂) aufweist, deren gemeinsame Grenzfläche (F) einen Übergang mit elektrisch gleichrichtender Funktion bildet.

7. Bauelement nach Anspruch 6, ausgeführt als Schottky-Kontakt-Wellenleiter (SKW), **dadurch gekennzeichnet, dass** die Anordnung zweier benachbarter Schichten (A₁, A₂) aus einer Halbleiterschicht (n-HL, p-HL, A₁) und einer Metallschicht (Me, A₂) besteht, deren gemeinsame Grenzfläche (F) einen Metall-Halbleiter-Übergang in Form eines Schottky-Kontakts (SK) bildet.

8. Bauelement nach Anspruch 6, ausgeführt als Wellenleiter mit einem p-n-Übergang, **dadurch gekennzeichnet, dass** die Anordnung zweier benachbarter Schichten (A₁, A₂) aus zwei unterschiedlich dotierten Halbleiterschichten (n-HL, p-HL) besteht, deren gemeinsame Grenzfläche (F) einen p-n-Übergang bildet.

9. Bauelement nach einem der Ansprüche 6, 7 oder 8, **dadurch gekennzeichnet, dass** die Anordnung zweier benachbarter Schichten (A₁, A₂) auf einem Substrat (S₁) positioniert ist.

10. Bauelement nach einem der Ansprüche 6, 7 oder 8, **dadurch gekennzeichnet, dass** die Anordnung zweier benachbarter Schichten (A₁, A₂) als Sandwich-Struktur zwischen zwei Substraten (S₁, S₂), die denselben oder einen ähnlichen Brechungsindex aufweisen, positioniert ist, sodass das Bauelement eine symmetrische Wellenleitergeometrie erhält.

11. Bauelement nach einem der Ansprüche 6 bis 10, **dadurch gekennzeichnet, dass** seine Wellenleitergeometrie für jeden Frequenzbereich, in dem das Bauelement einsetzbar ist, wählbar ist.

12. Verwendung eines Verfahrens nach einem der Ansprüche 1 bis 5 und eines Bauelements nach einem der Ansprüche 6 bis 11 zur Verbreiterung des Frequenzspektrums von elektromagnetischen Wellen, die von Emittern für den Radiowellen-Frequenzbereich bis hin zum UV-Frequenzbereich erzeugt werden.

13. Verwendung nach Anspruch 12, wobei das Verfahren nach einem der Ansprüche 1 bis 5 und das Bauelement nach einem der Ansprüche 6 bis 11 eingesetzt werden zur Verbreiterung des Frequenzspektrums von elektromagnetischen Wellen, die von Emittern für den Terahertz(THz)-Frequenzbereich erzeugt werden.

14. Verwendung nach Anspruch 13, wobei das Bauelement nach einem der Ansprüche 6 bis 13 in den THz-Pfad eines THz-Messgeräts eingebaut wird, wobei es zwischen dem THz-Emitter und dem Ort der Probenpositionierung platziert wird.

15. Verwendung nach Anspruch 14, **dadurch gekennzeichnet, dass** als THz-Messgerät ein THz-Zeitbereichsspektrometer, ein THz-Quasizeitbereichsspektrometer oder ein THz-Interferometer gewählt wird.
